# EUROPÄISCHE PATENTSCHRIFT

(11) **EP 2 266 122 B1**
(45) Veröffentlichungstag und Bekanntmachung des Hinweises auf die Patenterteilung: **08.01.2014**
(21) Anmeldenummer: 09733185.4
(22) Anmeldetag: 30.01.2009
(51) Int. Cl.: H01F 27/34, H05K 9/00, H01F 27/36

(54) **ELEKTROSTATISCHE ABSCHIRMUNG FÜR EINEN HGÜ-BAUTEIL**
ELECTROSTATIC SCREEN FOR AN HVDCT COMPONENT
BLINDAGE ELECTROSTATIQUE POUR COMPOSANT POUR TRANSMISSION D'ELECTRICITE EN COURANT CONTINU HAUTE TENSION

(30) Priorität: 18.04.2008 AT 6222008
(43) Veröffentlichungstag der Anmeldung: 29.12.2010
(73) Patentinhaber: Trench Austria GmbH, 4060 Leonding (AT)
(72) Erfinder: REISINGER, Helmut, A-4311 Schwertberg (AT); TUMA, Hermann, A-4082 Aschach (AT)
(74) Vertreter: Weiser, Andreas
(86) Internationale Anmeldenummer: PCT/AT2009/000032
(87) Internationale Veröffentlichungsnummer: WO 2009/126977

(56) Entgegenhaltungen:
- WO-A-2009/026960
- CA-A1- 1 114 465
- DE-A1- 3 634 946
- JP-A- 9 231 839
- US-A- 4 639 282

## Beschreibung

Die vorliegende Erfindung betrifft eine elektrostatische Abschirmung für einen HGÜ-Bauteil mit mindestens zwei Anschlüssen, insbesondere für eine HGÜ-Luftdrosselspule, gemäß dem Anspruch 1.

Bauteile für Hochspannungs-Gleichstromübertragungen (HGÜ) befinden sich im Betrieb auf hohem Potential gegenüber Erde, z.B. 500 bis 800 kV, und unterliegen dadurch einer kontinuierlichen und teilweise punktuell stark anwachsenden Verschmutzung, welche als "elektrostatic precipitation" oder "black spot"-Phänomen bekannt ist. Der Grund hiefür sind in der Atmosphäre stets vorhandene Ladungsträger wie Ionen, ionisierbare oder polarisierbare Staub- und Schmutzpartikel usw., die sich in dem starken elektrostatischen Feld zwischen dem Bauteil und seiner Umgebung zur Oberfläche des Bauteils bewegen und dort ablagern. Das Ausmaß der elektrostatischen Verschmutzung hängt nicht zuletzt von der Menge an in der Umgebung des Bauteils verfügbaren freien Ladungsträgern ab, wie sie sich von naheliegenden Zäunen, Stützen usw. ablösen und zur Oberfläche des Bauteils migrieren. Dies erzeugt nicht nur die erwähnten Verschmutzungen, sondern bedeutet auch einen Ladungsaufbau auf der äußeren Isolation des Bauteils, welcher zu lokalen Entladungen führen kann.

Die DE 36 34 946 A1 zeigt einen druckgas-isolierten HGÜ-Leiter, welcher mit Feststoffisolatoren gegen die Isoliergas-Hülle abgestützt ist. Die im Isoliergas angeordneten Feststoffisolatoren weisen eine Oberflächenbeschichtung mit einem Flächenwiderstand im Bereich zwischen 10¹² - 10¹⁸ Ohm/Quadrat auf, um Überschläge durch unkontrollierte Ladungsverteilung an der Oberfläche der Feststoffisolatoren infolge der Gleichstrombelastung zu vermeiden. Eine elektrostatische Verschmutzung der Feststoffisolatoren mit Partikeln aus der Umgebung ist in einer solchen Anordnung nicht gegeben.

Es wurden bereits verschiedene Lösungen vorgeschlagen, die elektrostatische Verschmutzung von HGÜ-Anlagen hintanzuhalten oder zumindest zu verringern. Als Beispiele seien die Verwendung eines Faraday' schen Käfigs rund um den Bauteil oder das Verstärken der äußeren Isolation, um zumindest punktuelle Entladungen zu verhindern, genannt. Diese Maßnahmen sind jedoch relativ aufwendig und zu kostspielig, um ihren Einsatz in der Praxis zu rechtfertigen, sodaß "black spot"-Phänomene bislang einfach hingenommen wurden.

Die Erfindung setzt sich zum Ziel, eine neuartige elektrostatische Abschirmung für HGÜ-Bauteile zu schaffen, welche auf kostengünstige und dennoch wirksame Art und Weise das Problem der elektrostatischen Verschmutzung überwindet und die Ausbildung von "black spots" verhindert. Dieses Ziel wird mit einer elektrostatischen Abschirmung mit den Merkmalen des Anspruchs 1 erreicht.

Auf diese Weise wird ein elektrostatischer Schirm geschaffen, der aufgrund der dissipativen Wirkung seines Mantelmaterials Ladungsträger von der Oberfläche des Bauteils abführen und damit eine elektrostatische Aufladung des Bauteils mit den geschilderten negativen Folgen verhindern kann, dabei aber gleichzeitig einen ausreichend hohen elektrischen Widerstand darbietet, um der am Bauteil zwischen den Anschlüssen abfallenden Spannung widerstehen zu können. Die vom Mantel aufgefangenen Ladungsträger werden zu der Kollektorelektrode und damit zu einem der Anschlüsse des Bauteils abgeführt. Aufgrund der umlaufenden Anordnung der Kollektorelektrode können die Ladungsträger dabei an jedem Umfangsort den kürzesten Weg zur Kollektorelektrode nehmen, was einen raschen Ladungsabbau sicherstellt. Die Fertigung des Mantels aus einer Folie gewährleistet eine weitgehend gleichmäßige Schichtdicke des dissipativen Materials rund um den Bauteil und ein einfaches Aufbringen des Mantels.

Gemäß einer bevorzugten Ausführungsform der Erfindung ist die Folie auf den Bauteil aufklebbar ist, was eine sichere Verankerung und überdies auch eine einfache Nachrüstung bestehender Bauteile ermöglicht.

Besonders vorteilhaft ist es, wenn die Folie in einander teilweise überlappenden Bahnen zu dem Mantel zusammengesetzt ist. Dadurch können Folienbahnen standardisierter Breite für unterschiedlichste Bauteilabmessungen verwendet werden; gleichzeitig wird eine ausgezeichnete Kontaktierung der nebeneinanderliegenden Bahnen erreicht.

Eine besonders vorteilhafte Ausführungsform der Erfindung zeichnet sich dadurch aus, daß das Material des Mantels ein Kunststoff ist, der ein intrinsisch dissipatives Polymer (IDP) enthält. Derartige Polymere wurden als Additive zur Herstellung elektrostatisch leitender Kunststoffe entwickelt, wie sie beispielsweise zur Verpackung organischer entflammbarer Granulate, zur Handhabung brennbarer oder explosiver Materialien, zur Verpackung elektrostatisch empfindlicher elektronischer Komponenten usw. Verwendung finden. IDP-Additive ermöglichen im Kunststoffverarbeitungsprozeß eine exakte Einstellung der Leitfähigkeit des Kunststoff-Endproduktes in Abhängigkeit von ihrem Beimischungsanteil und damit eine zuverlässige Erfüllung der oben genannten Anforderungen an Ladungsabbauvermögen und Spannungsfestigkeit.

Bevorzugt liegt der Oberflächenwiderstand des Mantelmaterials im Bereich von 10¹⁰ bis 10¹² Ohm/Quadrat, was einen ausgezeichneten Kompromiß zwischen Ladungsableitung einerseits und Spannungsfestigkeit zwischen den Anschlüssen anderseits ergibt.

Eine weitere bevorzugte Ausführungsform der Erfindung zeichnet sich dadurch aus, daß der Mantel an seinen beiden Enden mit je einer Kollektorelektrode zum Anschluß an je einen der Anschlüsse des Bauteils versehen ist. Dadurch können die mittleren Wege für die Ableitung der Ladungsträger signifikant verkürzt und die Entladungszeit der Abschirmung stark verringert werden.

Gemäß einer weiteren bevorzugten Ausführungsform der Abschirmung, welche für einen zylinderförmigen Bauteil bestimmt ist, ist der Mantel ebenfalls zylinderförmig und die Kollektorelektrode(n) ist bzw. sind ringförmig, wodurch eine enge Anpassung erreicht werden kann.

Für die Kollektorelektrode können beispielsweise Aluminiumstreifen, Kupferlitzengewebe usw. verwendet werden. Besonders vorteilhaft ist es, wenn die Kollektorelektrode(n) aus einem Kohlefaserband gefertigt ist/sind, was mechanische Festigkeit mit guter Leitfähigkeit verbindet.

In beiden Fällen ist es besonders günstig, wenn die Folie über die Kollektorelektrode(n) und diese kontaktierend aufgebracht ist, wodurch sich eine witterungsfeste Konstruktion ergibt.

Die Witterungsfestigkeit und Altersbeständigkeit kann noch weiter erhöht werden, wenn gemäß einem weiteren bevorzugten Merkmal der Erfindung das Material des Mantels auch einen UV-Stäbilisator enthält.

Die elektrostatische Abschirmung der Erfindung eignet sich für alle Arten von HGÜ-Bauteilen, die sich auf hohem Potential befinden. Eine besonders bevorzugte Anwendung ist eine HGÜ-Luftdrosselspule, die zumindest eine konzentrische Wicklungslage umfaßt, deren Anschlüsse an ihren. Ende liegen und welche so mit einer erfindungsgemäßen Abschirmung ausgestattet wird, daß der Mantel der Abschirmung auf die äußerste Wicklungslage aufgebracht und die Kollektorelektrode(n) der Abschirmung jeweils mit einem Anschluß verbunden wird bzw. werden. Dadurch wird eine elektrostatische Verschmutzung der Spule im Betrieb vermieden, die Ausbildung von "black spots" und punktuellen Entladungen verhindert und die Spule ist alterungsbeständig und witterungsfest.

Gemäß einer bevorzugten Variante der HGÜ-Luftdrosselspule kann der Mantel der Abschirmung auch auf eine starre Hilfs-Stützhülle aufgebracht werden, welche über Abstandhalter von der äußersten Wicklungslage beabstandet ist, wodurch ein zusätzlicher Kühlungs-Luftspalt zwischen der äußersten Wicklungslage und der Abschirmung erzielt wird. Dadurch kann eine Erwärmung der Abschirmung im Betrieb verhindert werden, was die Alterungsbeständigkeit noch weiter verbessert.

Die Erfindung wird nachstehend anhand eines in den beigeschlossenen Zeichnungen dargestellten Ausführungsbeispieles näher erläutert. In den Zeichnungen zeigen
die Fig. 1 und 2 die HGÜ-Luftdrosselspule der Erfindung in der Seitenansicht bzw. Draufsicht;
Fig. 3 die Abschirmung der HGÜ-Luftdrosselspule der Fig. 1 und 2 in der Perspektivansicht; und
Fig. 4 die Abschirmung von Fig. 3 in abgewickelter Darstellung.

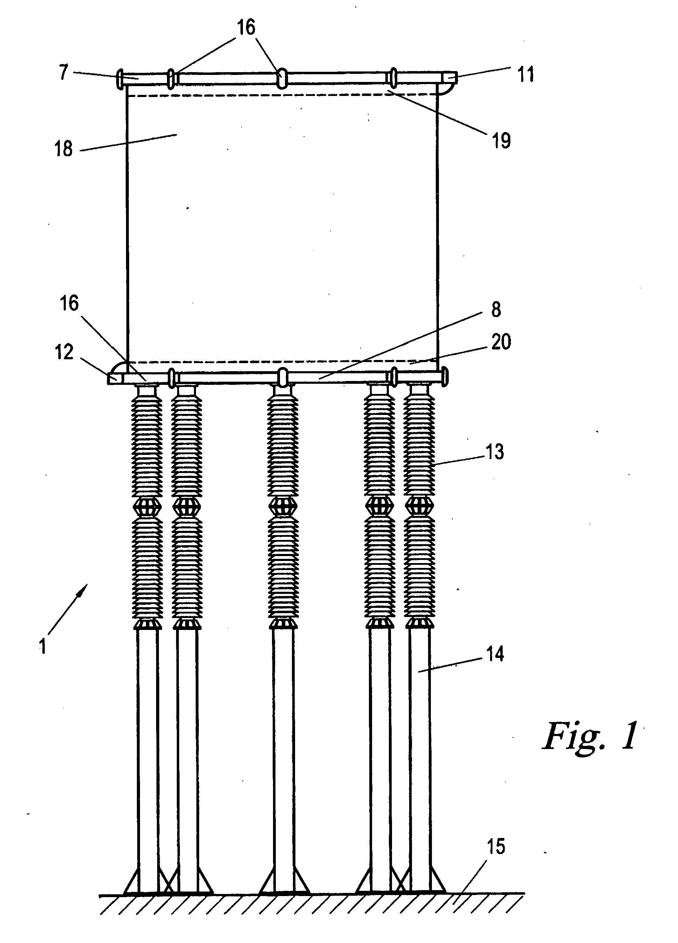

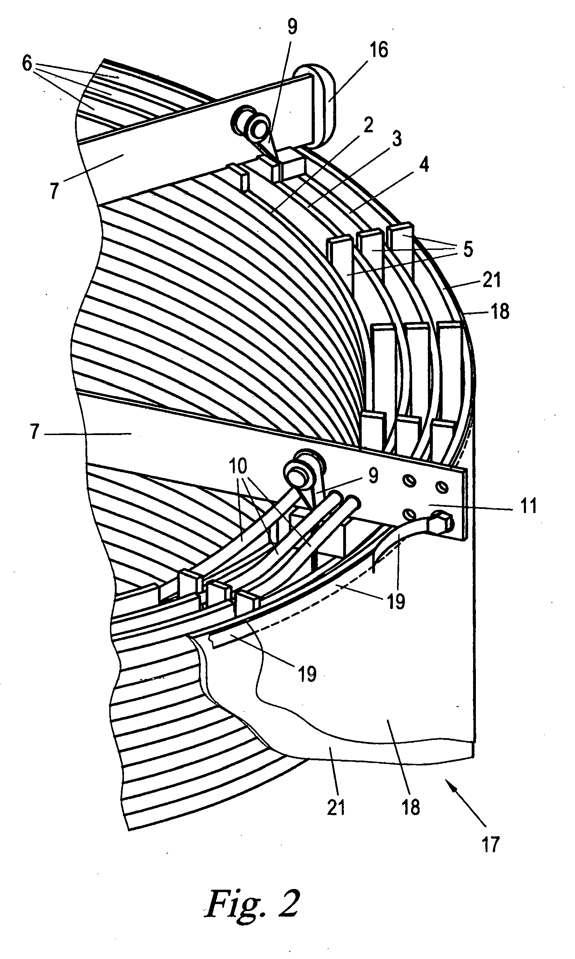

In den Fig. 1 und 2 ist eine HGÜ-Luftdrosselspule 1 dargestellt, wie sie beispielsweise bei Hochspannungs-Gleichstrom-Übertragungsstrecken (HGÜ) als Glättungsdrossel Anwendung findet.

Luftdrosselspulen sind - im Gegensatz zu ölisolierten Spulen - "trockenisolierte" Drosselspulen, bei welchen die umgebende Luft die äußere Isolation der Drosselspule bildet und welche in der Regel auch keinen ferromagnetischen Kern enthalten.

Die Luftdrosselspule 1 umfaßt im gezeigten Beispiel drei konzentrische, elektrisch parallelgeschaltete Wicklungslagen 2, 3, 4, welche durch Abstandhalter 5 voneinander beabstandet sind, um zwischeneinander Kühlungsluftspalte 6 zu bilden.

Die Wicklungslagen 2 - 4 werden an ihren oberen und unteren Enden von mehrarmigen Haltesternen 7, 8 zusammengehalten, welche über Spannbänder 9 gegeneinander gespannt sind. Die Leiter 10 der Wicklungslagen 2 - 4 sind mit den Haltesternen 7, 8 elektrisch verbunden und letztere weisen Anschlußfahnen auf, welche die Anschlüsse 11, 12 der Luftdrosselspule 1 bilden.

Die Luftdrosselspule 1 ist in vertikal stehender Lage über Isolatoren 13 und Stahlträger 14 gegen Erde 15 abgestützt. Im Betrieb liegt die Luftdrosselspule 1 auf hohem elektrischen Potential gegenüber Erde, beispielsweise 500 bis 800 kV, und führt einen Strom von bis zu 4000 A. Der Spannungsabfall über die Luftdrosselspule 1, d.h. zwischen ihren Anschlüssen 11, 12, ist im Vergleich dazu gering und entspricht etwa der Restwelligkeit der zu glättenden Spannung, in der Regel einige 100 Volt bis einige Kilovolt. Nur bei transienten Vorgängen, wie Schaltvorgängen oder Blitzschlägen, kann an der Luftdrosselspule 1 selbst eine signifikante Spannung abfallen, welcher die Isolation ihrer Wicklungen zwischen den Haltesternen 7, 8 standhalten muß. Schirmkappen 16 verhindern übermäßige lokale elektrische Feldstärken an spitzen Teilen wie den Enden der Haltesterne 7, 8.

Aufgrund des hohen Potentials der Luftdrosselspule 1 baut sich ein starkes elektrostatisches Feld zwischen der Außenseite der Luftdrosselspule 1 und der Erde 15 auf, welches zur Anlagerung von Ladungsträgern aus der Umgebung auf der äußersten Wicklungslage 4 mit den eingangs genannten Folgen der elektrostatischen Verschmutzung bzw. Ausbildung von "black spots" führen kann. Um dies zu verhindern, ist die Luftdrosselspule 1 mit einer elektrostatischen Abschirmung 17 versehen, welche nun anhand der Fig. 2 bis 4 näher erläutert wird.

Die elektrostatische Abschirmung 17 der HGÜ-Luftdrosselspule 1 umfaßt einen Mantel 18 aus elektrostatisch dissipativem Material mit einem Oberflächenwiderstand im Bereich von 10⁹ bis 10¹⁴ Ohm/Quadrat. Der Mantel 18 ist an seinen oberen und unteren Enden jeweils mit einer über einen großen Teil seines Umfangs, bevorzugt über seinen gesamten Umfang, verlaufenden Kollektorelektrode 19, 20 versehen, welche jeweils elektrisch mit dem oberen bzw. unteren Anschluß 11, 12 der Luftdrosselspule 1 verbunden ist.

Die Abschirmung 17 kann direkt auf die Außenseite der Luftdrosselspule 1 aufgebracht werden, d.h. der Mantel 18 direkt auf die Außenseite der äußersten Wicklungslage 4. Bei der in Fig. 2 gezeigten Ausführungsform wird optional zusätzlich eine starre Stützhülle 21 verwendet, die mittels Abstandhaltern 5 in einem Abstand zu der äußersten Wicklungslage 4 angeordnet ist und auf welche der Mantel 18 aufgebracht wird. Dadurch wird ein weiterer Luftspalt 6 zwischen der äußersten Wicklungslage 4 und der Abschirmung 17 errichtet, welcher zur Kühlung der Abschirmung 17 dient.

Aufgrund der dissipativen Wirkung des Materials des Mantels 18 werden die auf der Abschirmung 17 auftreffenden Ladungsträger jeweils auf kürzestem Weg zur nächstliegenden Kollektorelektrode 19, 20 und damit zu einem der Anschlüsse 11, 12 abgeleitet. Ein Ladungsaufbau auf der Außenseite der Luftdrosselspule 1 mit den eingangs geschilderten nachteiligen Folgen wird dadurch vermieden.

Das dissipative Material des Mantels 18 ist bevorzugt ein Kunststoff, welcher ein Additiv von der Gattung der intrinsisch dissipativen Polymere (IDP) enthält. Derartige IDP-Additive werden bei der Verarbeitung des Kunststoffs, z.B. durch Beifügen als Granulat während des Schmelzformvorganges, in die Polymermatrix des Kunststoffs eingebettet und bilden ein leitendes Fasernetzwerk im Kunststoff aus, über welches elektrostatische Ladungen rasch abgebaut ("dissipiert") werden. IDP-Additive gestatten eine exakt reproduzierbare Einstellung der Leitfähigkeit des Endprodukts in Abhängigkeit von ihrem Beimischungsverhältnis.

Für die Zwecke der vorliegenden Erfindung werden IDPs in einem solchen Ausmaß zum grundlegenden Kunststoffmaterial des Mantels 18 beigefügt, daß der Oberflächenwiderstand des fertiggestellten Mantels 18 im Bereich von 10⁹ bis 10¹⁴ Ohm/Quadrat liegt, besonders bevorzugt im Bereich 10¹⁰ bis 10¹² Ohm/Quadrat. Dadurch können Entladungsabbauzeiten ("charge decay times") von weniger als 0,02 Sekunden erreicht werden.

Beispielhafte Kunststoffmaterialien für den Mantel 18, welchen IDPs beigefügt werden können, umfassen - in nicht ausschließlicher Aufzählung - Anschlußypropylen (PP), Anschlußyethylen (PE), Anschlußyvinylchlorid (PVC), Acrylnitrilbutadienstyrol (ABS) u.dgl. Beispielhafte IDP-Additive zur Beimischung zum Kunststoffmaterial werden von der Firma Ciba Specialty Chemicals unter der Marke IRGASTAT^{®} vertrieben.

Das Beifügen der IDPs zum Kunststoffmaterial kann beispielsweise in granularer Form beim Blasformen oder Extrudieren des Kunststoffmaterials zu einer Folie für den Mantel 18 erfolgen. Dabei kann auch ein UV-Stabilisator zur Erhöhung der UV-Beständigkeit des Mantels 18 beigegeben werden.

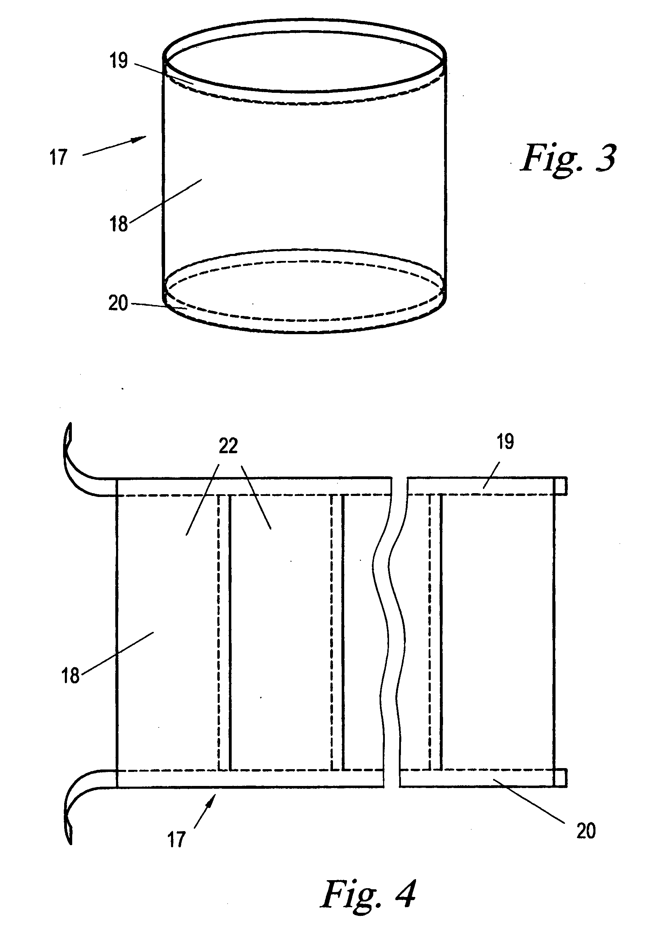

Der Mantel 18 ist, wie in Fig. 4 in abgewickelter Form gezeigt, aus etwa 50 cm breiten Bahnen einer Folie 22 zusammengesetzt, wobei die Bahnen mit einer gegenseitigen Überlappung von ca. 15 bis 40 mm zu dem zylinderförmigen Mantel 18 verbunden werden. Die Folie 22 kann selbstklebend sein, und die Folienbahnen können auf die Außenseite der Luftdrosselspule 1 bzw. die Außenseite der Stützhülle 21 aufgeklebt werden.

Die ringförmigen Kollektorelektroden 19, 20 können aus jedem beliebigen leitenden Material gefertigt werden, beispielsweise aus Kupferlitzen, Aluminiumstreifen oder bevorzugt aus Kohlefaserbändern. Bevorzugt werden bei der Fertigung der Abschirmung 17 zunächst die Kollektorelektroden 19, 20 auf die Außenseite der äußersten Wicklungslage 4 bzw. der Stützhülle 21 aufgebracht und mit den Anschlüssen 11, 12 verbunden, und anschließend wird in einem zweiten Schritt der Mantel 18 darüber aufgebracht, beispielsweise durch Aufkleben der Folie 22. Dadurch wird der Mantel 18 direkt mit den Kollektorelektroden 19, 20 kontaktiert.

Für die grundlegende Funktionsfähigkeit der Abschirmung 17 ist es nicht zwingend notwendig, zwei Kollektorelektroden 19, 20, d.h. eine an jedem Anschluß 11, 12, vorzusehen; im einfachsten Fall genügt eine einzige Kollektorelektrode am oberen oder unteren Ende des Mantels 18. Die Verwendung zweier gegenüberliegender Kollektorelektroden 19, 20 verkürzt jedoch die Wegstrecke für die Ableitung der Ladungsträger vom Mantel 18 und damit die Ladungsabbauzeit der Abschirmung 17.

Die erfindungsgemäße Abschirmung eignet sich zur antistatischen Ausrüstung beliebiger HGÜ-Bauteile, welche sich auf einem hohen Potential gegenüber Erde befinden, beispielsweise auch zur Abschirmung von Komponenten in gasisolierten Systemen (GIS) und allgemein für beliebige HGÜ-Anlagen.

Die Erfindung ist demgemäß nicht auf die dargestellten Ausführungsformen beschränkt, sondern umfaßt alle Varianten und Modifikationen, die in den Rahmen der angeschlossenen Ansprüche fallen.

## Patentansprüche

1. Elektrostatische Abschirmung (17) für einen HGÜ-Bauteil (1) mit zumindest zwei Anschlüssen (11, 12), insbesondere für eine HGÜ-Luftdrosselspule, mit einem Mantel (18), welcher aus einer Folie (22) aus elektrostatisch dissipativem Material gefertigt ist, wobei das elektrostatisch dissipative Material einen Oberflächenwiderstand im Bereich von 10⁹ bis 10¹⁴ Ohm/Quadrat aufweist, und wobei der Mantel an zumindest einem Ende mit einer im wesentlichen über seinen Umfang verlaufenden Kollektorelektrode (19, 20) zum Anschluß an einen der Anschlüsse (11, 12) des HGÜ-Bauteils (1) versehen ist.

2. Abschirmung nach Anspruch 1, **dadurch gekennzeichnet, daß** die Folie (22) auf den Bauteil (1) aufklebbar ist.

3. Abschirmung nach Anspruch 1 oder 2, **dadurch gekennzeichnet, daß** die Folie (22) in einander teilweise überlappenden Bahnen zu dem Mantel (18) zusammengesetzt ist.

4. Abschirmung nach einem der Ansprüche 1 bis 3, **dadurch gekennzeichnet, daß** das genannte Material ein Kunststoff ist, der ein intrinsisch dissipatives Polymer (IDP) enthält.

5. Abschirmung nach einem der Ansprüche 1 bis 4, **dadurch gekennzeichnet, daß** der genannte Oberflächenwiderstand im Bereich von 10¹⁰ bis 10¹² Ohm/Quadrat liegt.

6. Abschirmung nach einem der Ansprüche 1 bis 5, **dadurch gekennzeichnet, daß** der Mantel (18) an seinen beiden Enden mit je einer Kollektorelektrode (19, 20) zum Anschluß an je einen der Anschlüsse (11, 12) des Bauteils (1) versehen ist.

7. Abschirmung nach einem der Ansprüche 1 bis 6 für einen zylinderförmigen Bauteil, **dadurch gekennzeichnet, daß** der Mantel (18) zylinderförmig und die Kollektorelektrode(n) (19, 20) ringförmig ist/sind.

8. Abschirmung nach einem der Ansprüche 1 bis 7, **dadurch gekennzeichnet, daß** die Kollektorelektrode(n) (19, 20) aus einem Kohlefaserband gefertigt ist/sind.

9. Abschirmung nach einem der Ansprüche 1 bis 8, **dadurch gekennzeichnet, daß** die Folie (22) über die Kollektorelektrode(n) (19, 20) und diese kontaktierend aufgebracht ist.

10. Abschirmung nach einem der Ansprüche 1 bis 9, **dadurch gekennzeichnet, daß** das genannte Material ferner einen UV-Stabilisator enthält.

11. HGÜ-Luftdrosselspule, die zumindest eine konzentrische Wicklungslage (2 - 4) umfaßt und deren Anschlüsse (11, 12) an ihren Enden liegen, **gekennzeichnet durch** eine elektrostatische Abschirmung (17) nach einem der Ansprüche 1 bis 10, deren Mantel (18) auf die äußerste Wicklungslage (4) aufgebracht ist und deren Kollektorelektrode(n) (19, 20) jeweils mit einem Anschluß (11, 12) verbunden ist/sind.

12. HGÜ-Luftdrosselspule, die zumindest eine konzentrische Wicklungslage (2 - 4) umfaßt und deren Anschlüsse (11, 12) an ihren Enden liegen, **gekennzeichnet durch** eine elektrostatische Abschirmung (17) nach einem der Ansprüche 1 bis 10, deren Mantel (18) auf eine starre Stützhülle (21) aufgebracht ist, welche über Abstandhalter (5) von der äußersten Wicklungslage (4) beabstandet ist, und deren Kollektorelektrode(n) (19, 20) jeweils mit einem Anschluß (11, 12) verbunden ist/sind.

## Claims

1. Electrostatic shield (17) for an HVDC transmission component (1) with at least two terminals (11, 12), in particular for an HVDC transmission air-core coil, with a sheathing (18), which is made from a film (22) composed of electrostatically dissipative material, wherein the electrostatically dissipative material has a surface resistivity in the range of 10⁹ to 10¹⁴ ohm/square, and wherein the sheathing is provided on at least one end with a collector electrode (19, 20) running substantially over its periphery for connection to one of the terminals (11, 12) of the HVDC transmission component (1).

2. Shield according to claim 1, **characterised in that** the film (22) can be glued onto the component (1).

3. Shield according to claim 1 or 2, **characterised in that** the film (22) is joined together in partially overlapping sheets to form the sheathing (18).

4. Shield according to one of claims 1 to 3, **characterised in that** the said material is a plastic containing an intrinsically dissipative polymer (IDP).

5. Shield according to one of claims 1 to 4, **characterised in that** the said surface resistivity lies in the range of 10¹⁰ to 10¹² ohm/square.

6. Shield according to one of claims 1 to 5, **characterised in that** the sheathing (18) is provided at both its ends with a respective collector electrode (19, 20) for connection to one of the respective terminals (11, 12) of the component (1).

7. Shield according to one of claims 1 to 6 for a cylindrical component, **characterised in that** the sheathing (18) is cylindrical and the collector electrode(s) (19, 20) is/are ringshaped.

8. Shield according to one of claims 1 to 7, **characterised in that** the collector electrode(s) (19, 20) is/are made from a carbon fibre band.

9. Shield according to one of claims 1 to 8, **characterised in that** the film (22) is attached over the collector electrode(s) (19, 20) and in contact therewith.

10. Shield according to one of claims 1 to 9, **characterised in that** the said material additionally contains a UV stabiliser.

11. HVDC transmission air-core coil, which comprises at least one concentric winding layer (2 - 4), its terminals (11, 12) lying at its ends, **characterised by** an electrostatic shield (17) according to one of claims 1 to 10, the sheathing (18) of which is attached to the outermost winding layer (4) and the collector electrode(s) (19, 20) of which is/are respectively connected to a terminal (11, 12).

12. HVDC transmission air-core coil, which comprises at least one concentric winding layer (2 - 4), its terminals (11, 12) lying at its ends, **characterised by** an electrostatic shield (17) according to one of claims 1 to 10, the sheathing (18) of which is attached to a rigid support bush (21), which is spaced from the outermost winding layer (4) by means of spacers (5), and the collector electrode(s) (19, 20) of which is/are respectively connected to a terminal (11, 12).

## Revendications

1. Blindage électrostatique (17) pour un élément CCHT (1) avec au moins deux bornes (11, 12), en particulier pour une bobine d'inductance à air CCHT, avec une enveloppe (18) réalisée à partir d'une feuille (22) d'une matière antistatique, dans lequel la matière antistatique présente une résistivité surfacique dans la plage de 10⁹ à 10¹⁴ Ohms/carré, et dans lequel l'enveloppe est pourvue, à au moins une extrémité, d'une électrode de collecteur (19, 20) s'étendant essentiellement sur son pourtour, pour le raccordement à l'une des bornes (11, 12) de l'élément CCHT (1).

2. Blindage selon la revendication 1, **caractérisé en ce que** la feuille (22) peut être collée sur l'élément (1).

3. Blindage selon la revendication 1 ou 2, **caractérisé en ce que** la feuille (22) est composée de bandes partiellement superposées pour former l'enveloppe (18).

4. Blindage selon l'une des revendications 1 à 3, **caractérisé en ce que** ladite matière est une matière plastique contenant un polymère intrinsèquement dissipatif (IDP).

5. Blindage selon l'une des revendications 1 à 4, **caractérisé en ce que** ladite résistivité surfacique est comprise dans la plage de 10¹⁰ à 10¹² Ohms/carré.

6. Blindage selon l'une des revendications 1 à 5, **caractérisé en ce que** l'enveloppe (18) est pourvue, à chacune de ses deux extrémités, d'une électrode de collecteur (19, 20) pour le raccordement respectif à l'une des bornes (11, 12) de l'élément (1).

7. Blindage selon l'une des revendications 1 à 6, pour un élément cylindrique, **caractérisé en ce que** l'enveloppe (18) est cylindrique et la/les électrode(s) de collecteur (19, 20) est/sont annulaire(s).

8. Blindage selon l'une des revendications 1 à 7, **caractérisé en ce que** la/les électrode(s) de collecteur (19, 20) est/sont constituée(s) d'une bande en fibres de carbone.

9. Blindage selon l'une des revendications 1 à 8, **caractérisé en ce que** la feuille (22) est appliquée sur la/les électrode(s) de collecteur (19, 20) tout en étant en contact avec celle(s)-ci.

10. Blindage selon l'une des revendications 1 à 9, **caractérisé en ce que** ladite matière contient en outre un stabilisateur d'UV.

11. Bobine d'inductance à air CCHT, comprenant au moins une couche d'enroulement concentrique (2 - 4) et dont les bornes (11, 12) se trouvent à son extrémité, **caractérisée par** un blindage électrostatique (17) selon l'une des revendications 1 à 10, dont l'enveloppe (18) est appliquée sur la couche d'enroulement extérieure (4) et dont la/les électrode(s) de collecteur (19, 20) est/sont relié(s) respectivement à une borne (11, 12).

12. Bobine d'inductance à air CCHT comprenant au moins une couche d'enroulement concentrique (2 - 4) et dont les bornes (11, 12) se trouvent à ses extrémités, **caractérisée par** un blindage électrostatique (17) selon l'une des revendications 1 à 10, dont l'enveloppe (18) est appliquée sur une gaine fixe (21) espacée de la couche d'enroulement extérieure (4) par des espaceurs (5), et dont la/les électrode(s) de collecteur (19, 20) sont reliées respectivement à une borne (11, 12).
